# EUROPEAN PATENT APPLICATION

(11) **EP 4 029 969 A1**
(43) Date of publication of application: **20.07.2022**
(21) Application number: 22151411.0
(22) Date of filing: 13.01.2022
(51) Int. Cl.: C23C 16/455, C23C 16/30, B05D 5/00

(54) **A SUBSTRATE WITH A BIOCIDAL COATING AND A METHOD FOR FORMING A BIOCIDAL COATING ON A SUBSTRATE**

(30) Priority: 13.01.2021 PL 43665421
(71) Applicant: Saule Spolka Akcyjna, 02-676 Warszawa (PL)
(72) Inventor: Knor, Marek, 05-480 Pruszkow (PL); Bursa, Bartosz, 62-052 Rosnowko (PL); Kupczunas, Artur, 62-800 Kalisz (PL); Malinkiewicz, Olga, 50-251 Wroclaw (PL); Scigaj, Mateusz, 54-440 Wroclaw (PL)
(74) Representative: Kancelaria Eupatent.pl Sp. z.o.o

(57) **Abstract**

A substrate with a biocidal coating 10, which is covalently bound to the substrate 2, wherein the biocidal coating 10 has a berthollide structure, and comprises a top biocidal layer (11) comprising non-stoichiometric metal oxides and/or metal sulphides and/or metal nitrides selected from the group consisting of CuOₓ, TiOₓ, AlOₓ, SnOₓ, ZnOx, CrOₓ, NiOx, ZrOₓ, FeOx, CoOx, CuNₓ, TiNₓ, AlNₓ, SnNₓ, ZnNₓ, CrNₓ, NiNₓ, ZrNₓ, FeNₓ, CoNₓ, CuSx, TiSx, SnSx, ZnSx, CrSx, NiSx, ZrSx, FeSx and CoSx, wherein at least some of the metal atoms are bound to non-metal atoms (O, S, N) by covalent bonds.

## Description

### TECHNICAL FIELD

The present invention relates to a substrate having a coating with a top layer exhibiting biocidal properties, including virucidal and/or bactericidal properties, and a method for forming a biocidal coating on a substrate.

### BACKGROUND

Known measures of preventing the spread of pathogens include disinfecting surfaces in public spaces and disinfecting the body of users thereof, in particular hands, shoes and overcoats, using a variety of means such as exposing the surfaces to UV light and applying chemicals having a biocidal effect. These measures, however, are only temporary. Exposing surfaces to UV light only has an effect at the time of exposure, while later on pathogens are free to accumulate and multiply in the previously disinfected areas again. Indeed, known chemicals have a temporary and relatively short-lasting biocidal effect. For example, a surface that has been disinfected with 70 % ethanol may soon be colonised by further microorganisms. This is why, for surfaces such as door handles, trolley and shopping cart handles, payment terminal keypads and equipment of public sanitary facilities, disinfection needs to be carried out each time after they are used, which is time-consuming and labour-intensive, as well as having a negative impact on the natural environment due to the high consumption of chemicals which, once evaporated or washed away, penetrate into the environment and cause pollution, while UV radiation accelerates the degradation of plastics and thus contributes to their more rapid deterioration.

Proper disinfection of surfaces used in public spaces, however, is important due to microbiological hazards present in the environment. Under favourable conditions, some pathogens can survive on various surfaces for several hours to several days. For example, the SARS-COV-2 virus can survive on metal surfaces for several hours, and for up to three days on plastic surfaces, which increases the risk of transfer of this pathogen, thus increasing its spread.

Antibacterial, antiviral or antifungal agents are also known in the form of ions of some metals, including silver ions (Ag⁺), copper ions (Cu²⁺) and zinc ions (Zn²⁺), as well as in the form of metals comminuted to nanometric dimensions, such as nano-Ag, nano-Cu, nano-ZnO or nano-TiO₂.

Such biocidal agents are used as a base for producing various formulations with a targeted biocidal effect, such as coating compositions in the form of sprays or liquids which, when applied to a surface, form thin layers or films, for example, having an antibacterial and/or antiviral effect.

Such biocides are also used as additives in various plastics for the purpose of obtaining materials, and therefore entire plastic elements (parts) having a biocidal effect.

Polish patent publication PL223188 discloses a material with biocidal properties coated with spatially oriented titanium dioxide nanotubes, modified with precious metals such as silver, gold, platinum, palladium, ruthenium, copper, zinc, nickel, rhodium, tungsten, cobalt, iron. Precious metals (bimetals, trimetals) deposited on the surface of nanotubes have a core-shell and/or alloy structure, which renders said material biocidal. Moreover, the titanium dioxide nanotubes present in said material allow for a more efficient transport of photoexcited electrons, which results in activation of pollutant degradation processes on the surface of said coating. The method for obtaining said material includes the application of an electric current to a titanium-containing substrate placed in an electrolyte containing ammonium fluoride and ethylene glycol, ultrasonic cleaning followed by drying and calcination.

Polish patent description PL215354 discloses a method for obtaining polystyrene (PS) plastics with a biocidal agent: copper nanoparticles with an average primary grain size in the range of 1 to 1100 nm. The process of PS production comprises suspension polymerization of styrene with the addition of suspension stabilizers and copper nanoparticles in the amount of 0.0015 to 7% based on styrene, wherein copper is introduced into the polymerization mixture in the form of a powder or in the form of a dispersion of said powder in a solution of water, alcohol or water and alcohol. The resulting polystyrene is a composite product having improved resistance to mould, fungi and bacteria.

Polish patent application P.394557 describes paper coated with nano-additives: nanoparticles. The production process of said paper consists in spraying nanoparticles onto a formed paper web with a dryness of at least 6%, which ensures barrier properties of the produced paper, thus reducing penetration and migration of pollutants through the paper.

Comminuted to the nano-sized form, however, said biocides typically have poor affinity to the media in which they are present, including plastics or paper, and their small size of the order of nanometres make them diffuse relatively quickly into the environment, so that target materials or surfaces soon lose their biocidal properties.

### SUMMARY OF THE INVENTION

There is a need to provide a substrate comprising on its surface a biocidal coating that features limited diffusion of biocidal components thereof into the environment and, as a result, superior duration of its biocidal properties. Further, there is a need to provide a method allowing for producing such a biocidal coating on substrates made of various materials, as well as ensuring limited interference with the material of the substrate itself so that the material properties of the substrate itself are not impaired as a result of the biocidal coating being formed.

There is disclosed a substrate comprising a biocidal coating, characterised in that the biocidal coating 10 is covalently bound to the substrate 2, wherein the biocidal coating 10 has a berthollide structure, said biocidal coating 10 comprises a top biocidal layer 11 comprising non-stoichiometric metal oxides and/or metal sulphides and/or metal nitrides selected from the group consisting of CuOₓ, TiOₓ, AlOₓ, SnOₓ, ZnOₓ, CrOx, NiOx, ZrOx, FeOx, CoOx, CuNₓ, TiNₓ, AlNₓ, SnNₓ, ZnNₓ, CrNₓ, NiNₓ, ZrNₓ, FeNₓ, CoNₓ, CuSx, TiSx, SnSx, ZnSx, CrSx, NiSx, ZrSx, FeSx and CoSx, wherein at least some of the metal atoms are bound to non-metal atoms (O, S, N) by covalent bonds.

Preferably, the top biocidal layer 11 comprises non-stoichiometric metal oxides and/or metal sulphides and/or metal nitrides selected from the group consisting of CuOₓ, SnOₓ, FeOx, ZnOx, TiOₓ CuSx, SnSx, FeSx, ZnSx, CuNₓ, ZnNₓ and TiNₓ.

Preferably, the biocidal coating 10 further comprises an intermediate layer 12 arranged between the substrate 2 and the top biocidal layer 11, wherein the intermediate layer 12 is covalently bound to both the substrate 2 and the biocidal layer 11, said intermediate layer 12 comprises non-stoichiometric metal oxides and/or metal sulphides and/or metal nitrides selected from the group consisting of CuOₓ, TiOₓ, AlOₓ, SnOₓ, ZnOₓ, CrOx, NiOx, ZrOx, FeOx, CoOₓ, SiOx, CuNₓ, TiNₓ, AlNₓ, SnNₓ, ZnNₓ, CrNₓ, NiNₓ, ZrNₓ, FeNₓ, CoNₓ, CuSx, TiSₓ, SnSₓ, ZnSₓ, CrSx, NiSₓ, ZrSx, FeSₓ and CoSₓ, wherein at least some of the metal atoms are bound to non-metal atoms (O, S, N) by covalent bonds, and wherein a chemical composition of the intermediate layer 12 differs from a chemical composition of the biocidal layer 11 by a type of at least one element within the berthollide structure of the biocidal coating 10.

Preferably, the biocidal layer 11 comprises from two to three different types of the metals comprised in the berthollide structure of the biocidal coating 10.

Preferably, the intermediate layer 12 comprises from two to three different types of the metals comprised in the berthollide structure of the biocidal coating 10.

Preferably, the substrate 2 comprises at least one material selected from the group consisting of cellulose, polyester, polyamide, acryl, metallic material and/or ceramic material.

Preferably, the substrate 2 comprises at least one material selected from the group consisting of high density polyethylene (HDPE), low density polyethylene (LDPE), linear low density polyethylene (LLDPE), poly(ethylene-co-vinyl acetate) (EVA), at least one copolymer of ethylene and alkenes comprising from 4 to 8 carbon atoms, at least one propylene-ethylene copolymer, propylene-butene copolymer, tetrafluoroethylene-difluoroethylene copolymer, tetrafluoroethylene-ethylene copolymer, tetrafluoroethylene-hexafluoropropylene copolymer, polyvinyl chloride (PVC), polyvinyl chloride-vinyl acetate (PVCA) copolymer and/or mixtures comprising one or more of said polymers and/or said copolymers, wherein said material has plasma-treated or corona-treated surface.

Preferably, the substrate 2 is in a form of film, sheet, sponge, foam, fibre, knitted fabric, woven fabric, non-woven fabric, filter or membrane.

Preferably, the biocidal layer 11 of the biocidal coating 10 has a thickness of not more than 1 um.

Preferably, the intermediate layer 12 of the biocidal coating 10 has a thickness of not more than 50 nm.

Preferably, the biocidal layer 11 comprises at least one non-stoichiometric compound selected from the group consisting of CuOₓ, SnOₓ, FeOₓ, ZnOₓ, CuSₓ, SnSₓ, FeSₓ, ZnSₓ, CuNₓ, ZnNₓ and TiNₓ, and the intermediate layer 12 comprises at least one non-stoichiometric compound selected from the group consisting of: AlOₓ, TiOₓ and SiOₓ.

Further, there is disclosed a method for producing a biocidal coating on a substrate, characterised by comprising the steps of providing the substrate 2 having on its surface active functional moieties 1 selected from the group consisting of carboxy, hydroxy, carbonyl, epoxy, amide, primary amine, secondary amine, tertiary amine, imine and nitrile moieties; on the substrate 2, forming the biocidal coating 10 having a berthollide structure, including forming a top biocidal layer 11, wherein forming the top biocidal layer 11 comprises exposing said substrate 2 to precursors of the biocidal layer 11, in the gaseous phase, said precursors comprising: precursors comprising metal atoms selected from the group consisting of Cu, Ti, Al, Sn, Cr, Ni, Zr, Fe and Co, and precursors comprising non-metal atoms, being the compounds selected from the group consisting of H₂O, NH₃ and H₂S, to form the berthollide structure being covalently bound to the substrate 2, comprising at least one non-stoichiometric metal sulphide, metal nitride or metal oxide selected from the group consisting of CuOₓ, TiOₓ, AIOx, SnOₓ, ZnOₓ, CrOₓ, NiOₓ, ZrOₓ, FeOₓ, CoOₓ, CuNₓ, TiNₓ, AlNₓ, SnNₓ, ZnNₓ, CrNₓ, NiNₓ, ZrNₓ, FeNₓ, CoNₓ, CuSₓ, TiSₓ, SnSₓ, ZnSₓ, CrSₓ, NiSₓ, ZrSx, FeSx and CoSx.

Preferably, each of the berthollide structure precursor of the biocidal coating 10 comprises at least two functional moieties capable of reacting with the active moieties of the substrate 2 and/or the active functional moieties of the berthollide structure formed on said substrate 2 to form a covalent bond.

Preferably, the substrate 2 is exposed to the berthollide structure precursors of the biocidal layer 11.

Preferably, the step of forming the biocidal coating 10 further comprises forming an intermediate layer 12 of the biocidal coating 10 arranged between the substrate 2 and the biocidal layer 11 and being covalently bound to both the substrate 2 and the biocidal layer 11, said forming the intermediate layer 12 comprising exposing said substrate 2 to precursors of the intermediate layer 12, the precursors being supplied towards the substrate 2 in the gaseous phase, said precursors comprising: the precursors comprising metal atoms selected from the group consisting of Cu, Ti, Al, Sn, Cr, Ni, Zr, Fe Co and Si, and the precursors comprising non-metal atoms, being the compounds selected from the group consisting of H₂O, NH₃ and H₂S, to form the berthollide structure being covalently bound to both the substrate (2) and the top biocidal layer (11), comprising at least one non-stoichiometric metal sulphide, metal nitride or metal oxide selected from the group consisting of CuOₓ, TiOₓ, AlOₓ, SnOₓ, ZnOₓ, CrOₓ, NiOₓ, ZrOₓ, FeOₓ, CoOₓ, CuNₓ, TiNₓ, AlNₓ, SnNₓ, ZnNₓ, CrNₓ, NiNₓ, ZrNₓ, FeNₓ, CoNₓ, CuSx, TiSx, SnSx, ZnSx, CrSx, NiSx, ZrSx, FeSx and CoSx, wherein a chemical composition of the precursors of the intermediate layer 12 differs from a chemical composition of the precursors of the biocidal layer 11 by a type of at least one element within the berthollide structure of the biocidal coating 10.

Preferably, at least one of the precursors of the intermediate layer 11 comprises at least three functional moieties capable of reacting with the active functional moieties of the substrate 2 and/or the active functional moieties of the berthollide structure formed on said substrate 2, to form covalent bonds.

Preferably the method comprises supplying, to the substrate (2) being exposed, at least one of said precursors in a stream of carrier gas selected from the group consisting of: oxygen, nitrogen, argon, helium, hydrogen and water vapour, or a mixture of at least two of said carrier gases.

Preferably, all the precursors are fed towards the substrate 2 in a carrier gas stream.

Preferably, precursors used decompose to said non-stoichiometric metal oxides and/or metal sulphides and/or metal nitrides as a result of reacting with the active moieties of the substrate 2 and/or the active functional moieties of the berthollide structure formed on said substrate 2.

Preferably, the application is achieved in the carrier gas using a nozzle.

Preferably, the concentration of the precursors in the carrier gas is maintained between 0.001 and 12%.

Preferably, the concentration of precursors in the carrier gas is maintained at 1%.

Preferably, the substrate being exposed sequential exposure to the precursors containing metal atoms and to the precursors containing non-metal atoms.

Preferably, forming the biocidal coating 10 is carried out under a pressure in the range of 0.5 mbar to 1.5 bar.

Preferably, forming the biocidal coating 10 is carried out at atmospheric pressure.

Preferably, the method comprises forming the biocidal coating 10, on the substrate 2, using at least one technique selected from the group consisting of ALD (Atomic Layer Deposition), MLD (Molecular Layer Deposition), and CVD (Chemical Vapour Deposition).

Further aspects and features of the present invention are described in following description of the drawings.

### BRIEF DESCRIPTION OF DRAWINGS

Aspects and features of the present invention will become apparent by describing, in detail, exemplary embodiments of the present invention with reference to the attached drawings, in which:
Fig. 1 shows schematically a substrate with visible active functional moieties present on its surface, the substrate is intended to produce a biocidal coating thereon using the method according to the present invention;
Fig. 2 shows the steps of producing a top biocidal or intermediate layer on a substrate using the inventive method;
Fig. 3 - 5 show embodiments of the substrate comprising the top biocidal layer according to the present invention;
Fig. 6 shows the steps of producing the biocidal coating comprising the top biocidal layer and the intermediate layer, with the visible active functional moieties.

### DETAILED DESCRIPTION OF EMBODIMENTS

Reference will now be made to embodiments, examples of which are illustrated in the accompanying drawings. Aspects and features of the embodiments will be described with reference to the accompanying drawings. In the drawings, like reference numerals denote like elements. The present invention, however, may be embodied in various different forms and should not be construed as being limited only to the illustrated embodiments. Rather, these embodiments are provided as examples so that this disclosure will be thorough and complete, and will fully convey the aspects and features of the present invention to those skilled in the art. It shall be understood that not all of the features shown in the embodiments are essential and the scope of the protection is defined not by means of literally shown embodiments, but by the features provided in the claims.

The developed method allows for obtaining a coating 10 having biocidal properties on a substrate, which is covalently bound to said substrate. The coating 10, formed by the developed method, comprises an external top biocidal layer of biocidal effect. Optionally, the coating 10 may further comprise an intermediate layer between the top biocidal layer and the substrate. The biocidal coating 10 comprising the top biocidal layer 11 and optionally the intermediate layer 12, posses a berthollide structure - comprising non-stoichiometric compounds: one or more metal oxide, metal nitride and/or metal sulphide selected from the group consisting of: CuOₓ, TiOₓ, AlOₓ, SnOₓ, ZnOₓ, CrOₓ, NiOₓ, ZrOₓ, FeOₓ, CoOₓ, SiOₓ, CuNₓ, TiNₓ, AlNₓ, SnNₓ, ZnNₓ, CrNₓ, NiNₓ, ZrNₓ, FeNₓ, CoNₓ, CuSx, TiSx, SnSx, ZnSx, CrSx, NiSx, ZrSx, FeSₓ and CoSx, and more preferably the berthollide structure comprising one or more metal oxide, metal nitride and/or metal sulphide selected from the group consisting of: CuOₓ, SnOₓ, FeOₓ, ZnOₓ, TiOₓ CuSₓ, SnSₓ, FeSₓ, ZnSₓ, CuNₓ, ZnNₓ and TiNₓ. Due to the non-stoichiometric nature of the compounds of the berthollide type, x in the compounds listed above may denote different values, including nonintegers, and preferably x ranges from 0.5 to 2. For example, the biocidal coating 10 may comprise compounds of the berthollide type of the formula FeO_{1,4}, which may also be expressed as: Fe₂O_{2,8}.

The coating formed according to the developed method, comprises external the top biocidal layer has the berthollide structure comprising biocidal components that are covalently bound to the substrate, thus being bound to the substrate in a chemically- and thermodynamically-stable manner. As a result, the components of the biocidal coating according to the invention, including the biocidal components comprised in the top biocidal layer, do not tend to diffuse into the environment, and their concentration in the top layer does not change substantially over time. The achieved effect further restricts negative impact of the biocidal layer on the human body, since the penetration of the components of the top biocidal layer, having dimensions of the order of nanometres or less, into the human body, is significantly limited.

The achieved effect of biocidal properties of the coating, and more specifically of the top biocidal layer of the formed coating, may be a result of generation, in the structure of the above-mentioned berthollides, compounds which are the products of the Fenton reaction, i.e. strong oxidants containing active forms of oxygen, such as hydroxy radicals formed as a result of the reaction of hydrogen peroxide with metal, having a biocidal activity against microorganisms, including viruses and bacteria.

Due to the chemical nature of the formed permanent chemical bonds, i.e. the covalent bonds, the formed coating comprising the top biocidal layer can remain on the substrate for a long period of time - depending on ambient conditions - even up to several years, exhibiting, throughout said period, the biocidal effect of the top biocidal layer, including the virucidal effect.

The biocidal coating comprising the top biocidal layer and an optional intermediate layer, formed by the developed method, preferably constitutes an amorphous structure within the entire coating, optionally with minor presence of random small crystallites which do not influence the properties of the top biocidal layer of the coating and are not visible on a macroscopic scale. Namely, the coating, including its top biocidal layer, may contain crystalline regions of the order of nanometers and minor range.

Furthermore, in some embodiments, depending on the chemical composition, polycrystalline structures may be present within the coating, including the top biocidal layer of the coating.

However, in each embodiment, the coating comprising a top biocidal layer and an optional intermediate layer, obtained by the method according to the invention, constitutes a conformal, i.e. continuous, structure so that the coating tightly covers the surface of the substrate on which it was formed, regardless of the shape and roughness of the substrate, ensuring durable and uniform biocidal properties of the entire surface of the substrate comprising the coating. The coating according to the invention can be obtained both on smooth and rough substrates, as well as substrates of irregular structure, including in particular substrates in the form of textile materials of various types, such as for example knitted fabrics, woven fabrics, non-woven fabrics, terry fabrics, carpets, and on foil materials, as well as spongy and foam materials, including those with open pores, and other substrates in the form of structurally variable products, including in particular various air filters and fibres.

### Characteristics of the substrate for the coating with the top biocidal layer:

The coating comprising the top biocidal layer and optionally the intermediate layer, may be formed on various substrates having on their surface active functional moieties of one or more types, wherein the expression *'active functional moieties'* denotes chemical moieties bound to the substrate material, preferably by one or more covalent bonds, wherein said moieties are capable of reacting with at least one precursor of the biocidal layer and/or precursor of the intermediate layer of the coating to form a covalent bond. The term *"precursor"* denotes a chemical compound capable of reacting with active functional moieties of at least one type, directly or indirectly bound to a substrate by a covalent bond to form a further covalent bond, and optionally also other bonds, such as coordination bonds.

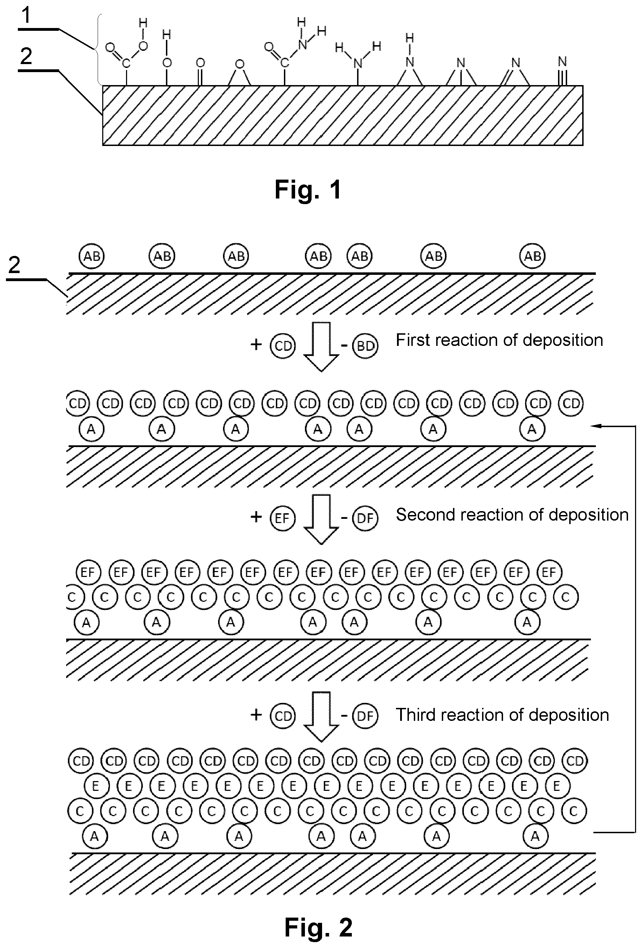

Fig. 1 shows schematically an exemplary substrate 2 with various active functional moieties 1 present on its surface. Preferably, the substrate may comprise the active functional moieties of one or more types, selected from the group consisting of a carboxy, hydroxy, carbonyl, epoxy, amide, primary amine, secondary amine, tertiary amine, imine and nitrile moieties. Thus, the substrate 2 may comprise one or more, such as two, three, four or more than four, such as, all the types of the active functional moieties 1 listed above, present on the surface of the substrate 2. The active functional moiety of the substrate 2 may be bound to the substrate directly as schematically illustrated in Fig. 1, or optionally indirectly, for example via a hydrocarbon chain, for example a straight or branched alkane chain, preferably comprising from 1 to 8 carbon atoms in the hydrocarbon chain.

In a preferred embodiment, the substrate 2 comprises carboxy and/or hydroxy moieties as the active functional moieties due to their high reactivity, and may also comprise further active functional moieties, listed above. Preferably, the proportion of carboxy and/or hydroxy functional moieties relative to all the active functional moieties 1 present on the surface of the substrate is the highest. This allows the biocidal coating 10 to be formed on said substrate 2 at relatively low temperatures, preferably at room temperature. Thus, the formation of the coating 10 can also be achieved on the substrates 2 made of materials sensitive to elevated temperatures without damaging them.

The active functional moieties 1 may be present on the surface of the substrate 2 in a statistical manner: regular, or in a random manner: irregular. The packing density of occurrence of the active functional moieties 1 per unit area of the substrate 2, that is, the value of the surface density of the active functional moieties 1 of the substrate 2 may vary, wherein the greater the value of the surface density of the active functional moieties 1 of the substrate 2, the greater the binding force between the substrate 1 and the coating 10 with the top biocidal layer 11 formed on said substrate 2, due to the greater number of covalent bonds formed between the coating 10 and the substrate 2. Furthermore, providing the substrate 2 having a relatively high surface density of the active functional moieties 1 has an effect on increasing the binding strength of the coating 10 with the substrate 2, both for the embodiment of the coating 10 comprising only the top biocidal layer as well as for the embodiment of the coating 10 comprising the top biocidal layer and the intermediate layer arranged between the substrate and the top biocidal layer. Alternatively, the substrates 2 with a lower surface density value of the active functional groups 1 may be used, thereby providing a biocidal layer with a lower bonding to the substrate, which may be a desirable feature in certain applications, such as, for example, to intentionally achieve periodic biocidal protection or to remove the biocidal layer with greater ease where necessary.

Accordingly, substrates 2 comprising any number of the active functional moieties 1 may be used according to the invention, depending on specific needs, including the target applicability of the substrate comprising the biocidal layer.

The presence of the active functional moieties 1, on the surface of the substrate 2, may be an inherent material feature of the substrate 2. Exemplary materials of the substrates 2 which, due to their chemical composition, comprise relatively large amounts of the active functional moieties 1, and can be used for forming the biocidal coating according to the invention, are polymeric materials derived from synthetic and natural polymers, preferably selected from: cellulose materials, such as, for example, paper, cardboard, cellulose fibres, or fibres with added cellulose, including, for example, cotton fibres, bamboo fibres, flax fibres, coconut fibres, or mixed fibres. Moreover, the substrate 2 may be made of a material or mixture of plastic materials, preferably including polyester, polyamide, acrylic, for example such as: polyethyl terephthalate and/or its copolymers, polyacrylonitrile and/or its copolymers, methyl polymethacrylate and/or its copolymers, polyamide-6 and/or its copolymers, polyamide-66 and/or its copolymers, modified fibres of cellulose origin, for example: viscose or modal, or mixtures of at least two different or all of said materials, in various forms, such as films, sheets, fibres or textile materials such as woven, knitted and/or non-woven fabrics, made of fibres consisting of one or more of said polymers, as well as mixtures of natural and/or synthetic polymers, such as polyester with cotton added.

Materials made of natural polymers such as cellulose contain a large number of the active functional moieties 1 on their surface, including hydroxy moieties, which are involved in the formation of the covalent bonds during the formation of the biocidal coating 10, which contributes to increased durability of the biocidal coating 10.

Using the developed method, the biocidal coating 10 may also be produced on various substrates covered with another coating or coatings, such as a coating of paint, varnish or enamel, for example in the form of prints on packaging, painted plastic elements or metals with an anti-corrosive coating. Furthermore, paints typically contain a significant share of inorganic pigments, which have hydroxy moieties on their surface; due to the presence of moisture from the atmosphere and diffusion of the bonds, and in coating compositions such as paints, varnishes and enamels, the binder used are polymers which may contain the active functional moieties 1 that are necessary to form the biocidal coating using the method according to the invention. Accordingly, the above-mentioned materials may also be used as the substrates for the production of the biocidal coating 10.

Moreover, using the method according to the invention, the biocidal coating 10 may also be formed on substrates made of materials comprising no active functional moieties on their surface, for example polyolefin materials, such as polyethylene (PE) or polypropylene (PP), as well as fluoropolymers, such as polytetrafluoroethylene (PTFE). In materials of this type, the active functional moieties 1 can be formed on the surface of the substrate 2 by activating the substrate 2 as a step of pretreatment of the substrate - prior to making the biocidal coating 10. Preferably, the activation of the substrate 2 can be carried out by a technique of corona-treating the substrate or exposing the substrate to plasma, for example using known equipment and conventional process parameters. For example, plasma or corona activation may be applied on materials such as: high density polyethylene (HDPE), low density polyethylene (LDPE), linear low density polyethylene (LLDPE), poly(ethylene-co-vinyl acetate) (EVA), copolymers such as copolymer of ethylene and alkenes comprising from 4 to 8 carbon atoms, or propylene-ethylene copolymer, propylene-butene copolymer, tetrafluoroethylene-difluoroethylene copolymer, tetrafluoroethylene-ethylene copolymer, tetrafluoroethylene-hexafluoropropylene copolymer, polyvinyl chloride (PVC), vinyl chloride-vinyl acetate (PVCA) copolymer and/or various mixtures comprising one or more of the above polymers or copolymers. According to the invention, the biocidal coating can be formed on the pre-activated materials, as described above. Preferably, the presence of the active functional moieties - shown in Fig. 1, on the surface of the polymer, is a direct result of the chemical nature of the polymer, and the plasma treatment only increases the concentration of the active functional moieties 1.

According the developed method, the biocidal coating 10 can also be formed on metal substrates, such as for example, aluminium, iron or steel. This is because the surface of metals is typically covered with oxides thereof, i.e. metals with a passive layer. These oxides, when exposed to moisture from the air, partially dissociate to form hydroxy moieties constituting the active functional moieties 1 on the surface of the substrate 2. Metals without an oxidised layer, in turn, can be pre-activated to form the active functional moieties.

### Method for forming the biocidal coating and its structure:

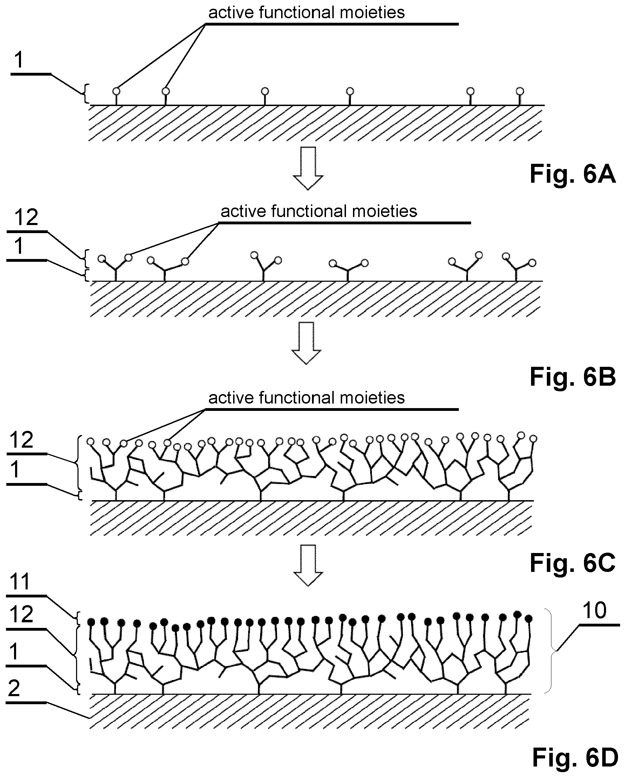

Formation of the biocidal coating 10 comprises providing a substrate 2 with the active functional moieties 1, which are schematically indicated in Fig. 2 as AB, forming the coating 10 on said substrate, comprising forming the top biocidal layer 11, optionally with forming the intermediate layer 12, between the top biocidal layer 11 and the substrate 2 - prior to forming the top biocidal layer 11, as schematically shown in Figs. 2 and 6. In case of the substrates comprising no active functional moieties 1 (AB), the method may also comprise a step of pre-activating the substrate 2 in order to form the active functional moieties (AB).

The intermediate layer 12, same like the top biocidal layer 12 of the coating 10, has a non-stoichiometric structure of the berthollide, in the form of listed-above variable composition compounds, i.e., at one metal oxide, metal nitride, and/or metallic sulphide which, wherein the intermediate layer 12, if present in the biocidal coating 10, is covalently bound to both the top biocidal layer 11 and the substrate 2. Presence of the intermediate layer 12 aims to increase the amount of the active functional moieties capable of reacting with the precursors of the top biocidal layer while forming the berthollide structure within the entire biocidal coating 10. Forming the intermediate layer 12 on the substrate yields a higher surface density of active functional moieties (Fig. 6A - 6C) which results in higher surface uniformity of the substrate 2 and improved binding of the top biocidal layer 11 with the substrate. Thus, the presence of the intermediate layer 12 between the biocidal layer and the substrate provides greater homogenisation of the entire structure of the biocidal coating 10 formed on the substrate 2 and increases the stability of the top biocidal layer 11 of said coating 10. The ratio of the thickness of the intermediate layer 12 to the thickness of the top biocidal layer 11 may vary. For example, the intermediate layer 12 may have a thickness of 90% of the entire coating 10, and the top biocidal layer may have the thickness of 10% of the entire coating 10.

As mentioned above, the biocidal coating 10 formed according to the method of the invention, comprising the top biocidal layer 11 and the optional intermediate layer 12, comprises a non-stoichiometric composition of the berthollides selected from the group consisting of metal oxides, metal nitrides and metal sulphides with the general formula MeEₓ.

In each of the embodiments, the top biocidal layer 11 of the coating 10 is covalently bound to the substrate 2. More specifically, the embodiments of the biocidal coating 10 in which there is no intermediate layer 12 present, the top biocidal layer 11 is directly covalently bound to the substrate; and the embodiments of the biocidal coating 10 in which the intermediate layer 12 of the coating 10 is present, the top biocidal layer 11, within the coating 10, is covalently bound to the substrate - indirectly: via the intermediate layer 11, since within the biocidal coating 10, the covalent bonds are present between the intermediate layer 12 and the substrate 2 and between the biocidal layer 11 and the substrate 2. Thus, the entire coating 10 consisting of the biocidal layer 11 and the intermediate layer 12 is bound to the substrate in a covalent manner, that is to say, by thermodynamically more stable binding. Said binding - through the covalent bonds, makes stable the top biocidal layer 11 of the coating 10 formed thereby, while the biocidal components comprised in the coating do not diffuse to the environment.

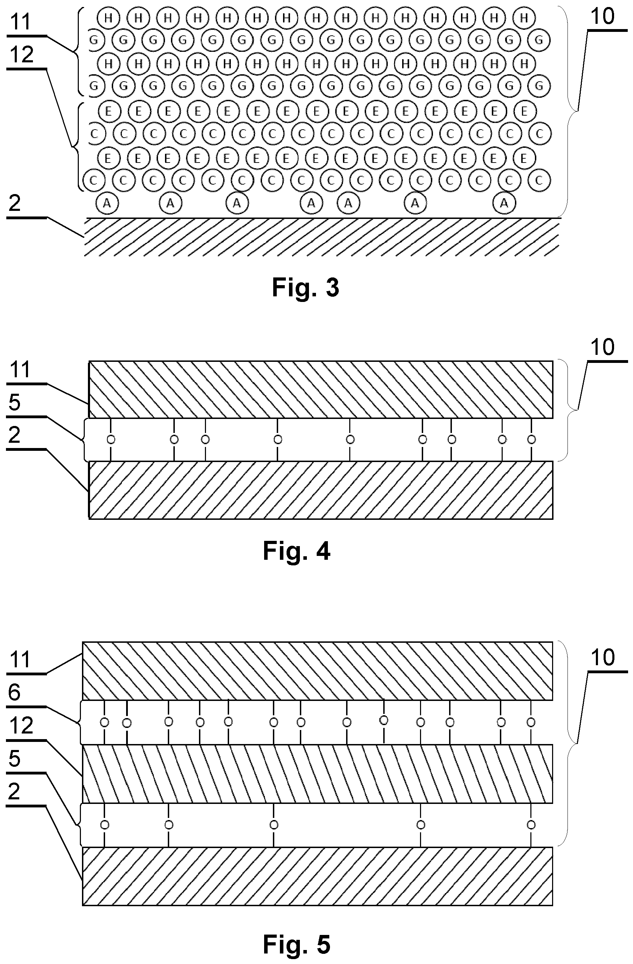

Fig. 4 schematically shows the substrate 2 comprising the biocidal coating 10 formed thereon; the biocidal coating 10 comprising the top biocidal layer 11 formed directly on the surface of the substrate 2, while Fig. 5 schematically shows the substrate 2 comprising the biocidal coating 10 formed thereon; the biocidal coating 10 comprising the intermediate layer 12 formed on the surface of the substrate 2 and the top biocidal layer 11 formed on the intermediate layer 12, which means that in this embodiment the top biocidal layer 11 is also formed on the substrate 2 which has been previously modified by forming the intermediate layer 12 thereon.

The biocidal coating 10 is formed on the substrate 2 by reacting the precursors of the berthollide structure, i.e. the precursors of the biocidal layer and optionally the precursors of the intermediate layer, respectively; the precursors being the chemical compounds capable of reacting with each other resulting in the formation of covalent bonds involving the formation of MeEₓ berthollide structures of the coating 10. The precursors of the top biocidal layer 11 and the precursors of the optional intermediate layer 12 include the precursors comprising atoms of a metal (Me) selected from the group consisting of: Cu, Ti, Al, Sn, Zn, Cr, Ni, Zr, Fe, Co, Si, and the precursors comprising non-metal atoms, said precursors are selected from the group of nitrides, sulphides and oxides to form, for example, sulphide and/or oxide and/or nitrogen bridges, as well as optionally other organic moieties. Fig. 4 and Fig. 5 schematically illustrate oxide bridges that may be present within the biocidal coating 10 comprising oxide bridges 5 between the substrate and the top biocidal layer (Fig. 4), as well as oxide bridges 5 between the substrate and the intermediate layer, as well as oxide bridges 6 between the intermediate layer and the top biocidal layer.

Fig. 2 schematically shows the method for forming the biocidal coating 10 on the substrate 2 comprising a step of forming the top biocidal layer 11 and optionally a step of forming the intermediate layer 12. The coating 10 is formed successively by alternation deposition of precursors comprising metal (Me) atoms and precursors comprising non-metal atoms, respectivelyat forming the intermediate layer 12 and at forming the biocidal layer 11. The deposition of the precursors involves chemical reactions of a given precursor with the active functional moieties present on the surface of the substrate 2 including formation of the covalent bonds, at each of the forming steps - as schematically shown in Fig. 6 by black lines. Preferably, as the precursors comprising non-metal atoms of both the intermediate layer 12 and the top biocidal layer 11, the precursors selected from the group consisting of H₂O, NH₃ and H₂S are used, and as the precursors comprising metal atoms various organic or inorganic metal compounds may be used, for example such as Al(CH₃)₃, Al(C₂H₅)₃, TiCl₄, tetrakis(dimethylamino)titanium (IV).

According to the developed method, the precursors comprising metal atoms of the biocidal layer 11 are compounds which preferably may have two or more functional moieties capable of forming the berthollide structure of biocidal properties. Preferably, the precursors of the top biocidal layer 11 are selected from the group of precursors capable of forming at least one layer of chemical composition selected from the group consisting of CuOₓ, SnOₓ, FeOₓ, ZnOₓ, TiOₓ CuSₓ, SnSₓ, FeSₓ, ZnSₓ, CuNₓ, ZnNₓ and TiNₓ.

Cheaper precursors comprising a metal atom that does not provide the biocidal effect of the formed berthollide structure can be comprised within the intermediate layer 12 of the coating 10, wherein at least one type among the precursors of the intermediate layer 11 comprises at least three and more preferably four active functional moieties capable of reacting with further precursors of the berthollide structure, to form covalent bonds and thus increase the thickness of the coating 10 during formation thereof. An example of the precursor for the intermediate layer is TiCl₄, which is a relatively cheap compound and has four functional moieties (Cl⁻) capable of further reactions with the formation of covalent bonds.

Due to the relatively high price of the precursors, the top biocidal layer 11 is preferably formed as thin as possible, thereby, forming thin top biocidal layer of the biocidal coating 10; the biocidal layer 11 preferably has a high packing density of molecules building up this layer, which provides improved biocidal properties of the coating 10, while keeping the material cost of the entire biocidal coating 10 relatively low.

According to the developed method, the precursors in gas phase are used for producing the biocidal coating 10. Gas phase enables the deposition of each precursor at atmospheric or near-atmospheric pressure conditions, and thus mild process conditions, which contributes to a significant reduction in process and equipment costs, while also reducing the risk of damaging the substrate 2 onto which the biocidal coating 10 is formed.

Preferably, the precursors in the gas phase are supplied to the substrate in a carrier gas selected from the group consisting of oxygen, nitrogen, argon, helium, hydrogen, water vapour or a mixture of at least two of said gases, e.g., by means of a nozzle, which provides improved contact of the precursors, so that the reactions of precursors deposition, leading to the deposition resulting in forming the berthollide structure, can be carried out at atmospheric pressure.

Preferably, concentration by weigh of the precursors in the carrier gas does not exceed 10%. In this form and under the predetermined conditions said precursors react with the active functional moieties present on the substrate surface, so that in the first step, the precursors reacts with the active functional moieties of the substrate, and the deposited precursors react next with the functional moieties present on the surface of the coating 10 whilst its being formed on the substrate - as schematically shown in Fig. 6.

The use of precursors in the gaseous phase mixed with the carrier gas can be used for example when coating substrates with uneven surface, including textile materials such as woven, knitted or non-woven fabrics, porous materials, filters. This is the result of the diffusion increasing the penetration of gas molecules into all fragments of the substrate material 2, which allows for the deposition of precursors on any, even the most diverse surface. The gas can freely penetrate through fibre weaves in the fabric or knitted fabric, reaching the surface of individual fibres and reacting there with the surface of the substrate 2 to form a chemically bound structure to form a covalent bond. The finally obtained biocidal layer 10 may be only a few nanometers thick, which makes it macroscopically unnoticeable without causing any mechanical or visual modification of the substrate 2 being coated, i.e. the utilised item. Thus, the developed method of forming the biocidal layer, with an optional intermediate layer, ensures that it is impossible to visually - macroscopically, distinguish the coated item with a biocidal layer from the item, thus the biocidal coating does not adversely affect the appearance and functionality of the products while ensuring their biocidal properties.

The process for forming the top biocidal layer 11 and the optional intermediate layer 12 is conducted at the temperature ranging from 20 to 150°C, under the pressure ranging from 0.5 mbar to 1.5 bar, preferably at a constant temperature below 100°C, under atmospheric pressure, wherein the reagents i.e. the precursors are supplied in gaseous state, in a carrier gas, this process conditions are mild which contribute to lower process costs. Moreover, it is also acceptable to carry out the process even at a pressure below 5 mbar, which increases considerably the process costs due to the complicated equipment that allows for converting the precursors into the gaseous state.

Preferably, the coating 10 may be produced using suitable precursors deposition techniques selected from the group consisting of: ALD (Atomic Layer Deposition), MLD (Molecular Layer Deposition), CVD (Chemical Vapour Deposition).

Using the ALD and MLD techniques, the biocidal layer 11 and/or the intermediate layer 12 may be produced by sequential exposure of the substrate 2 to at least two different precursors: the precursor containing a metal atom and the precursor containing a non-metal atom: S, N and/or O in the precursor molecule, in the gaseous phase, in the carrier gas, the precursors form on the surface a respective berthollide structure: an oxide, a nitride and/or a sulphide of at least one metal, or metal compounds with organic groups such as alcoholates or carboxylates which are more chemically complex - in the case of using MLD.

Using the CVD technique, the biocidal 11 and/or intermediate layer 12 of the coating 10 may be formed by sequentially exposing the substrate 2 to a mixture of suitable precursors in a carrier gas, the precursors undergo decomposition to form a suitable berthollide structure: an oxide, nitride and/or sulphide of at least one metal.

As illustrated in Fig. 2, the deposition of respective metal atom-comprising and non-metal atom-comprising precursors, including the precursors of the top biocidal layer and the precursors of the intermediate layer, in the course of formation of the coating 10, comprises a chemical reaction of the precursors in the gaseous phase. Preferably, from 1 to 100 reactions of alternating precursors may be conducted, i.e. the metal atom-containing precursors and non-metal atom-containing precursors - schematically designated as: CD and EF.

Each precursor CD, EF of the biocidal 11 layer of the coating 10 is a chemical compound with at least two functional moieties capable of reacting to form a covalent bond with the active functional moieties of the substrate 1 and/or the active functional moieties on the surface of the already formed intermediate layer, if any (Figs. 6A - 6C).

Further, at least one precursor of the intermediate layer comprises at least three, and more preferably four functional moieties capable of reacting to form the covalent bond with the active functional moieties of the substrate 1 (Fig. 6A) and/or functional moieties on the surface of the produced intermediate layer 12 (Figs. 6B, 6C), as described above.

For example, the precursor of the intermediate layer 12, as the first precursor CD - directly binding to the substrate 2 (Fig. 2) may have three or four functional moieties and/or the precursor of intermediate layer 12 used as the second precursor EF - binding to the precursor CD, may have three or four functional moieties. This makes each further reaction - resulting in covalent binding of another precursor 12 - increasing the number of active functional moieties on the surface of the layer being formed, thereby, resulting in denser packing of the active functional moieties of the surface of the substrate 2 in the biocidal layer 11, which directly correlates with the biocidal effectiveness thereof.

As illustrated in Fig. 2, in the first step of forming the biocidal layer 11 or the intermediate layer 12, the active functional moieties 1 of the substrate (AB), due to their non-metallic nature, may react with metal atom-containing precursors, schematically designated as CD, wherein each CD precursor, to form covalent bonds, may contain two to four functional moieties, e.g. TiCl₄. Depending on the chemical structure of the functional moieties, the conducted reaction may be a substitution reaction involving a release of a by-product: schematically designated as BD, DF, preferably in the form of gas, since it can be easily removed from the reaction environment by way of diffusion. In another embodiment, the reaction conducted (Fig. 2) may be an addition reaction, for example to a double bond, or ring opening, for example an epoxy ring opening. For example, epoxy groups are formed on the surface of substrate 2 as a result of its prior ozone or corona treatment in order to activate the substrate.

As a result of the sequential reactions of the respective biocidal layer precursors with the active functional moieties 1 of the substrate 2 and the structure formed on the substrate, the coating 10 with the top biocidal layer 11 is obtained. The top biocidal layer 11 of the coating 10 has the berthollide structure which, when reacting with moisture from the air, may have oxidised metal atoms on its surface: in the form of oxide or hydroxide.

The reactions leading to the formation of the respective layers: the intermediate layer 12 or the biocidal layer 11 within the coating 10, may be conducted by alternating the same precursors, for example alternating the TiCl₄ precursor with H₂O to form gaseous by-products, such as HCI, according to the schematic diagram of Fig. 2. In other words: the substrate 2 with the active functional moieties 1 may be treated alternately with EF and CD precursors to form a structure chemically bound to the substrate, together making a non-stoichiometric structure (berthollide) involving the release of further by-products DF. It is further acceptable to mix precursors containing non-metal atoms and to supply them into the reaction space simultaneously, for example mixing H₂O and NH₃, or mixing two different precursors containing metal atoms, such as a TiCl₄ precursor and a Al(CH₃)₃ precursor and/or Zn(C₂H₅)₂ precursor. As a result, mixed berthollide structures are obtained, which additionally provides: obtaining multidirectional biocidal properties, such as bactericidal and virucidal properties within the biocidal layer.

For an embodiment where between the substrate 2 and the biocidal layer 11 the intermediate layer 12 is also formed, three different precursors may be used, including one precursor being common to the intermediate layer 12 and the biocidal layer 11, such as H₂O, or four different precursors: two precursors for the intermediate layer 12 and two different precursors for the biocidal layer 11, for example, for the intermediate layer precursors: TiCl₄ and H₂O, and for the biocidal layer precursors: Zn(C₂H₅)₂ and H₂S. Further, non-limiting examples of the precursors of the intermediate layer 12 include: TiCl₄ and H₂O, trimethylaluminum and H₂O, triethylaluminum and H₂O, trimethylaluminum and NH₃, and/or triethylaluminum and NH₃. Further, non-limiting examples of the precursors of the biocidal layer 12 include: diethyl zinc and H₂O, diethyl zinc and NH₃, diethyl zinc and H₂S, tetrakis(dimethylamino)tin and H₂O, tetrakis(dimethylamino)tin and NH₃, tetrakis(dimethylamino)tin and H₂S, copper (I) acetate and H₂O, copper (I) acetate and NH₃, copper (I) acetate and H₂S, bis(N-tert-butyl-N'-ethylpropionamidinato) cobalt (II) and H₂O, bis(N-tert-butyl-N'-ethylpropionamidinato) cobalt (II) and NH₃, bis(N-tert-butyl-N'-ethylpropionamidinato) cobalt (II) and H₂S, nickel (II) 1-dimethylamino-2-methyl-2-propoxide and H₂O, nickel (II) 1-dimethylamino-2-methyl-2- propoxide and NH₃, nickel (II) 1-dimethylamino-2-methyl-2- propoxide and H₂S, iron (III) chloride and H₂O, iron (III) chloride and NH₃, iron (III) chloride and H₂S, zirconium chloride (IV) and H₂O, zirconium chloride (IV) and NH₃, and/or zirconium chloride (IV) and H₂S.

The biocidal coating 10, obtained by the developed method, features no significant change in the visual properties of the substrate since it is translucent, and in some embodiments transparent, said coating 10 further features no change in the surface texture due to its small thickness: preferably, the biocidal layer 11 of the coating 10 formed on the substrate 2 may have a thickness of not more than 1 um, more preferably not more than 100 nm, or not more than 10 nm. The optional intermediate layer 12 of the coating 10 may have a thickness of not more than 50 um, or more preferably not more than 5 um.

Moreover, the biocidal coating 10: with the biocidal layer 11 and the intermediate layer 12, if present, does not limit the utility parameters of the respective material or object that is made of the material which is the substrate 2.

Preferably, the developed method may be applicable in the production of the substrates having the biocidal coating 10 with the following composition of the intermediate layer/biocidal layer: AlOₓ/ZnOₓ; plasma-activated substrate: N₂/AlOₓ/ZnO; AlOₓ/SnOₓ; plasma-activated substrate: N₂/AlOₓ /SnOₓ; AlOₓ /TiOₓ; plasma-activated substrate: N₂/AlOₓ /TiOx; AlOₓ/CuOₓ.

One of the advantages of the developed method for producing the biocidal coating 10 is the deposition of precursors: those containing metal atoms and those containing non-metal atoms in the gaseous phase (in the form of vapour of said compounds), or in the gaseous phase in a carrier gas. This allows the process to be conducted at or near atmospheric pressure, which reduces the risk of damage to the substrate exposed to gaseous precursors, so that the biocidal coating can be produced on substrates made of different materials. Moreover, the precursors in the gas phase contained in the carrier gas have improved penetration into porous, irregular substrates, including those in the form of fibres, knitted fabrics, woven fabrics. Thus, the developed method makes it possible to obtain biocidal coatings 10 according to the invention having a conformal nature also on substrates with an irregular structure, which provides additional improvement of their biocidal properties of the coating 10.

### EMBODIMENTS:

### Embodiment 1:

A 100g/m² polyester fabric was subjected to a corona discharge in an air atmosphere for the purpose of activation thereof comprising the formation of active functional moieties on the fibre surface. An intermediate layer was then deposited on the fabric by subjecting the fabric to reaction cycles including alternating exposure to two precursors: trimethylaluminum vapour and water vapour at a pressure of 5 mbar. Between the exposure to trimethylaluminium vapour and water vapour, nitrogen was also fed into the system at 5 mbar. Thus, a single reaction cycle comprised the activity of precursors in the gas phase and nitrogen in the following order: trimethylaluminum, nitrogen, water vapour, nitrogen. The number of cycles in the entire intermediate layer application process was 20. The fabric was then similarly exposed to two precursors: diethyl zinc vapour and water vapour for 10 cycles. All cycles were run at a temperature of 80°C.

### Embodiment 2:

A 100g/m² cotton fabric was subjected to (N₂) nitrogen plasma for the purpose of activation thereof comprising the formation of active functional moieties on the cotton fibre surface. An intermediate layer was then deposited on the fabric by subjecting the fabric to reaction cycles including alternating exposure to the following precursors: trimethylaluminum vapour and water vapour at a pressure of 5 mbar. Between the exposure to trimethylaluminium vapour and water vapour, nitrogen was also fed into the system at 5 mbar. Thus, a single reaction cycle comprised the activity of precursors in the gas phase and nitrogen in the following order: trimethylaluminum, nitrogen, water vapour, nitrogen. The number of cycles in the entire intermediate layer application process was 20. The fabric was then similarly exposed to diethyl zinc vapour and water vapour for 10 cycles. All cycles were run at a temperature of 80°C. The resulting product was a substrate with a biocidal coating.

### Embodiment 3:

A 100g/m² cotton fabric was subjected to (N₂) nitrogen plasma for the purpose of activation thereof comprising the formation of active functional moieties on the cellulose fibre surface. An intermediate layer was then deposited thereon by subjecting the fabric to reaction cycles including alternating exposure to the following precursors: titanium tetrachloride vapour and water vapour at a pressure of 2 mbar. Between the exposure to titanium tetrachloride and water vapour, nitrogen was also fed into the system at 2 mbar. Thus, a single reaction cycle comprised the activity of precursors in the gas phase and nitrogen in the following order: titanium tetrachloride, nitrogen, water vapour, nitrogen. The number of cycles in the entire intermediate layer application process was 10. The fabric was then similarly exposed to diethyl zinc vapour and water vapour for 10 cycles in order to form a top biocidal layer. All cycles were run at a temperature of 100°C. The resulting product was a substrate with a biocidal coating.

### Embodiment 4:

A 100g/m² cotton fabric was subjected to nitrogen plasma for the purpose of activation thereof comprising the formation of active functional moieties on the cellulose fibre surface. An intermediate layer was deposited thereon by subjecting the fabric to reaction cycles including alternating exposure to precursors: trimethylaluminium vapour in nitrogen as carrier gas and water vapour, also in nitrogen, as carrier gas at atmospheric pressure. The partial pressure of trimethylaluminium vapour was 1 mbar, while that of water vapour was 2 mbar. Between the exposure to trimethylaluminium vapour in nitrogen and water vapour in nitrogen, pure nitrogen was also fed to the system at atmospheric pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The fabric was then similarly treated with diethyl zinc vapour in nitrogen as a carrier gas and water vapour in nitrogen as a carrier gas for 10 cycles in order to produce a biocidal layer. All cycles were run at a temperature of 80°C. The resulting product was a substrate with a biocidal coating.

### Embodiment 5:

A 100g/m² cotton fabric was subjected to nitrogen plasma for the purpose of activation thereof comprising the formation of active functional moieties on the fibre surface. The intermediate layer was then deposited thereon by subjecting the fabric to reaction cycles consisting of alternating exposure to triethylaluminum vapour and ammonia at a pressure of 2 mbar. Between the exposure to triethylaluminum and ammonia vapour, nitrogen was also fed into the system at 2 mbar. Thus, a single reaction cycle comprised the activity of vapour in the following order: triethylaluminum, nitrogen, ammonia, nitrogen. The number of cycles in the entire intermediate layer application process was 20. The fabric was then similarly exposed to tetrakis(dimethylamino)tin vapour and water vapour for 10 cycles in order to form a biocidal layer. All cycles were run at a temperature of 120°C. The resulting product was a substrate with a biocidal coating.

### Embodiment 6:

A 100g/m² polyester fabric was subjected to nitrogen plasma for the purpose of activation thereof comprising the formation of active functional moieties on the fibre surface. The intermediate layer was then deposited thereon by subjecting the fabric to reaction cycles consisting of alternating exposure to triethylaluminum vapour and water vapour at a pressure of 2 mbar. Between the exposure to triethylaluminium vapour and water vapour, nitrogen was also fed into the system at 2 mbar. Thus, a single reaction cycle comprised the activity of vapour in the following order: triethylaluminum, nitrogen, water vapour, nitrogen. The number of cycles in the entire intermediate layer application process was 20. The fabric was then similarly exposed to tetrakis(dimethylamino)tin vapour and water vapour for 10 cycles in order to form a biocidal layer. All cycles were run at a temperature of 100°C. The resulting product was a substrate with a biocidal coating. In analogous manner, the layers may be deposited onto the polyester-containing material in any form, including film, sheet, sponge, foam, fibre, knitted fabric, non-woven fabric, filter, or membrane.

### Embodiment 7:

A 100g/m² polyamid fabric was subjected to oxygen plasma for the purpose of activation thereof comprising the formation of active functional moieties on the fibre surface. The intermediate layer was then deposited thereon by subjecting the fabric to reaction cycles consisting of alternating exposure to trimethylaluminum vapour and water vapour at a pressure of 2 mbar. Between the exposure to trimethylaluminium vapour and water vapour, nitrogen was also fed into the system at 2 mbar. Thus, a single reaction cycle comprised the activity of vapour in the following order: triethylaluminum, nitrogen, water vapour, nitrogen. The number of cycles in the entire intermediate layer application process was 10. The fabric was then similarly exposed to tetrakis(dimethylamino)tin vapour and water vapour for 5 cycles in order to form a biocidal layer. All cycles were run at a temperature of 100°C. The resulting product was a substrate with a biocidal coating. Layers may be deposited onto the polyamid-containing material in any form, including film, sheets, sponge, foam, fibre, knitted fabric, woven fabric, non-woven fabric, filter, or membrane, in a similar manner. In the example given, the polyamide may also be replaced with acrylic polymer, cellulose or any other plasma-activated polymer to form reactive groups on the surface of the polymer according to Fig. 1, wherein preferably the reactive groups shown in Fig. 1 are present on the surface of the polymer that derive directly from the chemical nature of the polymer, with plasma treatment only increasing the concentration thereof.

### Embodiment 8:

A 0.1 mm thick 316L stainless steel plate was exposed to nitrogen plasma in order to clean the surface and to activate it, including the formation of active functional moieties on the steel surface. An intermediate layer was deposited thereon by subjecting the plate to reaction cycles including alternating exposure to precursors: trimethylaluminium vapour in nitrogen as carrier gas and water vapour, also in nitrogen, as carrier gas at atmospheric pressure. The partial pressure of trimethylaluminium vapour was 2 mbar, while that of water vapour was 5 mbar. Between the exposure to trimethylaluminium vapour in nitrogen and water vapour in nitrogen, pure nitrogen was also fed to the system at atmospheric pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with diethyl zinc vapour in nitrogen as a carrier gas and water vapour in nitrogen as a carrier gas for 10 cycles in order to produce a biocidal layer. All cycles were run at a temperature of 120°C. The resulting product was a substrate with the biocidal coating.

In analogous manner, on the surfaces of other metal alloys (except gold), the biocidal coatings may be formed, since most metals, when reacting with oxygen from air or water vapour form a surface, are covered with reactive hydroxyl groups or oxygen bridges capable of reacting with an organometallic precursor such as, for example, trimethylaluminum. Other substrates according to this embodiment may include for example: Al7004 or other aluminium alloys, brass or other zinc alloys, bronze, carbon steel.

### Embodiment 9:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with diethyl zinc vapour in nitrogen as a carrier gas and water vapour in nitrogen as a carrier gas for 10 cycles in order to produce a biocidal layer. All cycles were run at a temperature of 150°C. The resulting product was the substrate with the biocidal coating. In analogous manner, the biocidal coatings on the surface of other ceramic substrates (except gold) may be formed.

### Embodiment 10:

On a 1 mm thick glass plate, an intermediate layer was deposited by subjecting the plate to reaction cycles including alternating exposure to precursors: trimethylaluminium vapour at 1 mbar pressure and ammonia vapour at 5 mbar pressure. Between the exposure to trimethylaluminum and ammonia vapour, nitrogen was also supplied into the system at 5 mbar pressure. Thus, a single reaction cycle comprised the activity of vapour in the following order: trimethylaluminum, nitrogen, ammonia, nitrogen. The number of cycles in the entire intermediate layer application process was 20. The plate was then similarly exposed to diethyl zinc vapour and ammonia vapour for 10 cycles in order to form a biocidal layer. All the cycles were run at a temperature of 300°C. The resulting product was the substrate with the biocidal coating.

### Embodiment 11:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with copper(I) acetate vapour in nitrogen as a carrier gas and water vapour in nitrogen as a carrier gas for 10 cycles in order to produce a biocidal layer. All cycles were run at a temperature of 200°C. The resulting product was the substrate with the biocidal coating.

### Embodiment 12:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with bis(N-tert-butyl-N'-ethylpropionamidinato) cobalt (II) vapour in nitrogen as a carrier gas and water vapour in nitrogen as a carrier gas for 10 cycles in order to produce a biocidal layer. All cycles were run at a temperature of 200°C. The resulting product was the substrate with the biocidal coating.

### Embodiment 13:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with nickel(II) 1-dimethylamino-2-methyl-2-propoxide (abbreviated as Ni(dmamp)2) vapour in nitrogen as a carrier gas and water vapour in nitrogen as a carrier gas for 10 cycles in order to produce a biocidal layer. All cycles were run at a temperature of 120°C. The resulting product was the substrate with the biocidal coating.

### Embodiment 14:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with iron(III) chloride vapour in nitrogen as a carrier gas and water vapour in nitrogen as a carrier gas for 10 cycles in order to produce a biocidal layer. All cycles were run at a temperature of 250°C. The resulting product was a substrate with a biocidal coating.

### Embodiment 15:

On a 1 mm thick glass plate, an intermediate layer was deposited by subjecting the plate to reaction cycles including alternating exposure to precursors: trimethylaluminium vapour in nitrogen as carrier gas and water vapour, also in nitrogen as carrier gas at 5 mbar pressure. Between the exposure to trimethylaluminium vapour in nitrogen and water vapour in nitrogen, pure nitrogen was also fed to the system at 5 mbar pressure. Thus, a single reaction cycle comprised the activity of vapour in the following order: trimethylaluminium in carrier gas, nitrogen, water vapour in carrier gas, nitrogen. The number of cycles in the entire intermediate layer application process was 20. The plate was then similarly treated with zirconium (IV) chloride vapour in nitrogen as a carrier gas and water vapour in nitrogen as a carrier gas for 10 cycles in order to produce a biocidal layer. All cycles were run at a temperature of 300°C. The resulting product was the substrate with the biocidal coating.

### Embodiment 16:

On a 1 mm thick glass plate, an intermediate layer was deposited by subjecting the plate to reaction cycles including alternating exposure to precursors: trimethylaluminium vapour in argon as carrier gas and water vapour, also in argon as carrier gas at 5 mbar pressure. Between the exposure to trimethylaluminium vapour in argon and water vapour in argon, pure argon was also fed to the system at 5 mbar pressure. Thus, a single reaction cycle comprised the activity of vapour in the following order: trimethylaluminium in carrier gas, argon, water vapour in carrier gas, argon. The number of cycles in the entire intermediate layer application process was 20. The plate was then similarly treated with tetrakis(dimethylamino)tin vapour in argon as a carrier gas and hydrogen sulphide in argon as a carrier gas for 10 cycles in order to produce a biocidal layer. All cycles were run at a temperature of 150°C. The resulting product was a substrate with a biocidal coating. In analogous manner, the biocidal coatings on the surface of other ceramic substrates may be formed.

**Embodiment 17** - evaluation of the biocidal properties of a coating:
Identical samples were prepared as follows: the biocidal coating was formed on 1 cm x 1 cm substrates made of a polyester film as in Embodiment 6. All samples were then UV-sterilised and placed in a multi-well culture vessel. 10 µl influenza virus lysate (Influenza A Virus A/Virginia/ATCC11/2009 Ct = 22) was applied to each of the samples, spread and left on their surface. Moreover, a negative control was prepared as follows: a sample of a polyester film without the active layer applied with the virus lysate applied, as well as a positive control, i.e. a film without the virus lysate applied. The plates were left at room temperature. At the following time points: 1h, 3h, 6h, 12h, 24h, the virus was collected from the wells and suspended in 1 ml DMEM + AA Dulbecco's Modified Eagle's medium + agar-agar) medium and frozen. After collecting all samples, the following reagent was added to the collected viral lysates: TCPK Trypsin (trypsin treated with N-tosyl-L-phenylalanine chloromethyl ketone) (TPCK), and this was applied to MDCK.2 ( Madin-Darby canine kidney) cells. After 110 min incubation, lysates were collected, and fresh DMEM + AA + TPCK Trypsin medium was added to the cells. The cells were incubated for 11-5 days (observation of the cytopathic effect). The samples were then collected, and the virus CT was determined.

The results obtained are presented below:
- virus on a reference coating (without biocidal coating) measurement after 1h Ct = 34.43; measurement after 3h Ct = 37.05; measurements after 6h and 12h - virus undetectable.
- virus on the biocidal coating (obtained using the developed method): measurement after 1h - **virus undetectable.**

The obtained results thus confirmed the biocidal properties of the inventive coating. Specifically: for the substrate with the reference coating (without the biocidal coating), the virus was undetectable only after 6 hours, wherein the virus was detected for this substrate after 1 hour and after three hours at Ct = 34.43 and Ct = 37.05, respectively. For the substrate with the biocidal coating according to the invention, however, under the same conditions no virus was detected after 1 hour. Thus, the substrate with the biocidal coating according to the invention provides conditions that are more hindering for the persistence of the virus at least 6 times compared to the substrates without the biocidal coating obtained by the developed method.

The first measurement of the presence of the virus on the substrates was done only after 1 hour due to equipment capability. It is supposed, however, that the virus persists for much less than 1 hour on substrates with the inventive coating.

A virus on a plastic substrate with the inventive biocidal layer persist only for a maximum of 1 hour, which significantly reduces the risk of spreading this type of pathogens. As a result, surfaces with the inventive coating do not need to be additionally sterilised, for example with chemicals, which reduces both sterilisation costs of various surfaces, e.g. public use surfaces, and the negative environmental impact of sterilisation due to chemicals.

## Claims

1. A substrate comprising a biocidal coating, **characterised in that** the biocidal coating (10) is covalently bound to the substrate (2), wherein the biocidal coating (10) has a berthollide structure, and comprises a top biocidal layer (11) comprising non-stoichiometric metal oxides and/or metal sulphides and/or metal nitrides selected from the group consisting of CuOx, TiOx, AIOx, SnOx, ZnOx, CrOx, NiOx, ZrOx, FeOx, CoOx, CuNₓ, TiNₓ, AlNₓ, SnNₓ, ZnNₓ, CrNₓ, NiNₓ, ZrNₓ, FeNₓ, CoNₓ, CuSₓ, TiSₓ, SnSₓ, ZnSₓ, CrSₓ, NiSₓ, ZrSₓ, FeSₓ and CoSₓ, wherein at least some of the metal atoms are bound to non-metal atoms (O, S, N) by covalent bonds.

2. The substrate comprising the biocidal coating, **characterised in that** the top biocidal layer (11) comprises non-stoichiometric metal oxides and/or metal sulphides and/or metal nitrides selected from the group consisting of CuOₓ, SnOₓ, FeOₓ, ZnOₓ, TiOₓ CuSₓ, SnSₓ, FeSₓ, ZnSₓ, CuNₓ, ZnNₓ and TiNₓ.

3. The substrate according to claim 1 or 2, **characterised in that** the biocidal coating (10) further comprises an intermediate layer (12) arranged between the substrate (2) and the top biocidal layer (11), wherein the intermediate layer (12) is covalently bound to both the substrate (2) and the biocidal layer (11), wherein said intermediate layer (12) comprises non-stoichiometric metal oxides and/or metal sulphides and/or metal nitrides selected from the group consisting of CuOₓ, TiOₓ, AlOₓ, SnOₓ, ZnOₓ, CrOₓ, NiOₓ, ZrOₓ, FeOₓ, CoOₓ, SiOₓ, CuNₓ, TiNₓ, AlNₓ, SnNₓ, ZnNₓ, CrNₓ, NiNₓ, ZrNₓ, FeNₓ, CoNₓ, CuSₓ, TiSₓ, SnSₓ, ZnSₓ, CrSₓ, NiSₓ, ZrSₓ, FeSₓ and CoSx, wherein at least some of the metal atoms are bound to non-metal atoms (O, S, N) by covalent bonds, and wherein a chemical composition of the intermediate layer (12) differs from a chemical composition of the biocidal layer (11) by a type of at least one element within the berthollide structure of the biocidal coating (10).

4. The substrate according to any one of the preceding claims, **characterised in that** the biocidal layer (11) comprises from one to three types of the metals comprised in the berthollide structure of the biocidal coating (10).

5. The substrate according to claim 3 or 4, **characterised in that** the intermediate layer (12) comprises from one to three types of the metals comprised in the berthollide structure of the biocidal coating (10).

6. The substrate according to any one of the preceding claims, **characterised in that** the substrate (2) comprises at least one material selected from the group consisting of cellulose, polyester, polyamide, acryl, metallic material and/or ceramic material.

7. The substrate according to any one of claims 1 to 5, **characterised in that** the substrate (2) comprises at least one material selected from the group consisting of high density polyethylene (HDPE), low density polyethylene (LDPE), linear low density polyethylene (LLDPE), poly(ethylene-co-vinyl acetate) (EVA), at least one copolymer of ethylene and alkenes comprising from 4 to 8 carbon atoms, at least one propylene-ethylene copolymer, propylene-butene copolymer, tetrafluoroethylene-difluoroethylene copolymer, tetrafluoroethylene-ethylene copolymer, tetrafluoroethylene-hexafluoropropylene copolymer, polyvinyl chloride (PVC), polyvinyl chloride-vinyl acetate (PVCA) copolymer and/or mixtures comprising one or more of said polymers and/or said copolymers, wherein said material has plasma-treated or corona-treated surface.

8. The substrate according to any one of the preceding claims, **characterised in that** the substrate (2) is in a form of film, sheet, sponge, foam, fibre, knitted fabric, woven fabric, non-woven fabric, filter or membrane.

9. The substrate according to any one of claims 1 to 8, **characterised in that** the biocidal layer (11) comprises at least one non-stoichiometric compound selected from the group consisting of CuOₓ, SnOₓ, FeOₓ, ZnOₓ, CuSₓ, SnSₓ, FeSₓ, ZnSₓ, CuNₓ, ZnNₓ and TiNₓ, and the intermediate layer (12) comprises at least one non-stoichiometric compound selected from the group consisting of: AlOₓ, TiOₓ and SiOₓ.

10. A method for producing a biocidal coating on a substrate, **characterised by** comprising the steps of:
- providing the substrate (2) having on its surface active functional moieties (1) selected from the group consisting of carboxy, hydroxy, carbonyl, epoxy, amide, primary amine, secondary amine, tertiary amine, imine and nitrile moieties,
- on the substrate (2), forming the biocidal coating (10) having a berthollide structure, including forming a top biocidal layer (11), wherein forming the top biocidal layer (11) comprises exposing said substrate (2) to precursors of the biocidal layer (11), in the gaseous phase, said precursors comprising:
precursors comprising metal atoms selected from the group consisting of Cu, Ti, Al, Sn, Cr, Ni, Zr, Fe and Co, and
precursors comprising non-metal atoms, being the compounds selected from the group consisting of H₂O, NH₃ and H₂S,
to form the berthollide structure being covalently bound to the substrate (2), comprising at least one non-stoichiometric metal sulphide, metal nitride or metal oxide selected from the group consisting of CuOₓ, TiOₓ, AlOₓ, SnOₓ, ZnOₓ, CrOₓ, NiOₓ, ZrOₓ, FeOₓ, CoOₓ, CuNₓ, TiNₓ, AlNₓ, SnNₓ, ZnNₓ, CrNₓ, NiNₓ, ZrNₓ, FeNₓ, CoNₓ, CuSₓ, TiSₓ, SnSₓ, ZnSₓ, CrSₓ, NiSₓ, ZrSₓ, FeSₓ and CoSₓ.

11. The method according to claim 10, **characterised in that**
- the step of forming the biocidal coating (10) further comprises forming an intermediate layer (12) of the biocidal coating (10) arranged between the substrate (2) and the biocidal layer (11) and being covalently bound to both the substrate (2) and the biocidal layer (11), said forming the intermediate layer (12) comprising exposing said substrate (2) to precursors of the intermediate layer (12), the precursors being supplied towards the substrate (2) in the gaseous phase, said precursors comprising:
the precursors comprising metal atoms selected from the group consisting of Cu, Ti, Al, Sn, Cr, Ni, Zr, Fe Co and Si, and
the precursors comprising non-metal atoms, being the compounds selected from the group consisting of H₂O, NH₃ and H₂S,
to form the berthollide structure being covalently bound to both the substrate (2) and the top biocidal layer (11), comprising at least one non-stoichiometric metal sulphide, metal nitride or metal oxide selected from the group consisting of CuOₓ, TiOₓ, AlOₓ, SnOₓ, ZnOx, CrOx, NiOx, ZrOx, FeOx, CoOx, CuNₓ, TiNₓ, AlNₓ, SnNₓ, ZnNₓ, CrNₓ, NiNₓ, ZrNₓ, FeNₓ, CoNₓ, CuSx, TiSx, SnSx, ZnSx, CrSx, NiSx, ZrSx, FeSx and CoSx,
wherein a chemical composition of the precursors of the intermediate layer (12) differs from a chemical composition of the precursors of the biocidal layer (11) by a type of at least one element within the berthollide structure of the biocidal coating (10).

12. The method according to claim 11, **characterised in that** the at least one of the precursors of the intermediate layer (11) comprises at least three functional moieties capable of reacting with the active functional moieties of the substrate (2) and/or the active functional moieties of the berthollide structure formed on said substrate (2), to form covalent bonds.

13. The method according to any one of claims 10 to 12, **characterised by** supplying, to the substrate (2) being exposed, at least one of said precursors in a stream of carrier gas selected from the group consisting of: oxygen, nitrogen, argon, helium, hydrogen and water vapour, or a mixture of at least two of said carrier gases.

14. The method according to any one of claims 10 to 13, **characterised by** forming the biocidal coating (10) under a pressure in the range of 0.5 mbar to 1.5 bar.

15. The method according to any one of the claims 10 to 14, **characterised by** forming the biocidal coating (10), on the substrate (2), using at least one technique selected from the group consisting of ALD (Atomic Layer Deposition), MLD (Molecular Layer Deposition), and CVD (Chemical Vapour Deposition).
